# EUROPEAN PATENT APPLICATION

(11) **EP 4 730 040 A1**
(43) Date of publication of application: **22.04.2026**
(21) Application number: 25205680.9
(22) Date of filing: 30.09.2025
(51) Int. Cl.: G03F 7/40

(54) **PHOTORESIST PATTERN FORMING METHOD AND SEMICONDUCTOR DEVICE MANUFACTURED USING THE SAME**

(30) Priority: 16.10.2024 KR 20240140944
(71) Applicant: Ycchem Co., Ltd., Gyeongsangbuk-do 40046 (KR)
(72) Inventor: Lee, Su Jin, 40046 Seongju-gun (KR); Kim, Gi Hong, 40046 Seongju-gun (KR); Lim, Hyun Chan, 40046 Seongju-gun (KR); Lee, Seung Hun, 40046 Seongju-gun (KR); Lee, Seung Hyun, 40046 Seongju-gun (KR)
(74) Representative: Vossius & Partner Patentanwälte Rechtsanwälte mbB

(57) **Abstract**

A photoresist pattern forming method for forming a pattern with an increased aspect ratio using a typical photoresist and a semiconductor device manufactured using the same. The photoresist pattern forming method can reduce pattern collapse defects during a post-cleaning spin-drying process by using heated ultrapure water and/or a heated rinse solution in a cleaning step, thereby enhancing the overall process yield and providing a semiconductor device having enhanced performance.

## Description

### CROSS-REFERENCE TO RELATED APPLICATION

This patent document claims the benefit of Korean Patent Application No. 10-2024-0140944, filed on October 16, 2024, the entire disclosure of which is incorporated by reference for all purposes as if fully set forth herein.

### TECHNICAL FIELD

The present invention relates to a photoresist pattern forming method and a semiconductor device manufactured using the same.

### BACKGROUND

In semiconductor manufacturing, the critical dimension (CD) of a pattern formed in a photolithography process using a photoresist is influenced by diffraction characteristics of light used for irradiation. To improve the performance of semiconductors, it is crucial to achieve a smaller CD to increase integration density. KrF light and ArF light have been used in an exposure step to form finer patterns. Currently, even finer CDs can be achieved using extreme ultraviolet (EUV, 13.5 nm) photolithography technology.

However, given that etching resistance of EUV photoresists is still insufficient, it is necessary to maintain a certain minimum pattern thickness to prevent defects during an etching process while reducing the pattern critical dimension to form a fine pattern. This necessitates a photoresist pattern with a further increased aspect ratio. However, increase in aspect ratio of the photoresist pattern can cause increase in pattern collapse defects during post-exposure development and cleaning processes, resulting in significant reduction in process margin.

To reduce such pattern collapse defects, research is ongoing to enhance the physical properties of EUV photoresists. However, developing new photoresists that satisfy all the necessary properties remains a significant challenge.

In this regard, Korean Patent Laid-open Publication No. 10-2015-0093098 discloses a method of cleaning a photoresist pattern using a cleaning solution containing a fluorine compound. However, this method is limited in its ability to prevent pattern collapse defects due to recent increase in aspect ratio of photoresist patterns and has problems such as occurrence of watermarks due to insufficient drying of the cleaning solution.

Therefore, there is a need for a new photoresist pattern forming method that can reduce pattern collapse defects while allowing formation of a pattern with an increased aspect ratio.

### <Related Literature>

### <Patent Document>

(Patent Document 0001) Korean Patent Laid-open Publication No. 10-2015-0093098

### SUMMARY

Embodiments of the present invention have been conceived to solve such problems in the art and it is an aspect of the present invention to provide a photoresist pattern forming method that can reduce pattern collapse defects during a spin-drying process using after cleaning with ultrapure water and/or a rinse solution while allowing formation of a photoresist pattern with an increased aspect ratio using a typical photoresist.

It is another aspect of the present invention to provide a semiconductor device with improved performance, which is manufactured using the photoresist pattern forming method set forth above.

However, it should be understood that aspects of the present invention are not limited to those described above. The above and other aspects of the present invention will become apparent to those skilled in the art from the detailed description of the following embodiments in conjunction with the accompanying drawings.

**In** accordance with one aspect of the present invention, a method of forming a photoresist pattern includes the steps of: (a) forming a photoresist film by applying a photoresist composition to a substrate; (b) exposing the formed photoresist film to light; (c) developing the photoresist film exposed to the light using a developer; and (d) cleaning the developed photoresist film, wherein step (d) sequentially includes cleaning with ultrapure water and cleaning with a rinse solution, and at least one of the ultrapure water or the rinse solution used in step (d) is sprayed at a temperature of 30°C to 90°C.

At least one of the ultrapure water or the rinse solution used in step (d) may be sprayed at a temperature of 50°C to 80°C.

At least one of the ultrapure water or the rinse solution used in step (d) may be sprayed at a temperature of 65°C to 75°C.

The step of cleaning with ultrapure water may include spraying the ultrapure water onto the substrate at a flow rate of 1 ml/min to 2,000 ml/min for 1 sec to 300 sec while rotating the substrate at a speed of 1 rpm to 2,000 rpm.

The step of cleaning with a rinse solution may include spraying the rinse solution onto the substrate at a flow rate of 1 ml/min to 1,000 ml/min for 1 sec to 100 sec while rotating the substrate at a speed of 1 rpm to 1,500 rpm.

The rinse solution may include a surfactant, an additive, and water.

The rinse solution may include: 0.0001 wt% to 1 wt% of the surfactant; 0.0001 wt% to 1 wt% of the additive; and the balance of the water, based on the total weight of the rinse solution.

The photoresist pattern may have a critical dimension of 25 nm or less.

The photoresist pattern may have an aspect ratio (height/critical dimension) of 1.5 or more.

The light used in step (b) may be one selected from the group consisting of KrF, ArF, VUV, ArFi, and EUV.

In accordance with another aspect of the present invention, a semiconductor device is manufactured using the method of forming a photoresist pattern set forth above.

The method of forming a photoresist pattern according to the present invention can reduce the occurrence of pattern collapse defects during a post-cleaning spin-drying process by using heated ultrapure water and/or a heated rinse solution in a cleaning step while allowing formation of a photoresist pattern with an increased aspect ratio using a typical photoresist.

In addition, the method of forming a photoresist pattern according to the present invention can enhance the overall process yield by preventing pattern collapse defects during the cleaning step while allowing formation of fine patterns with an increased aspect ratio, thereby ensuring improved performance of a semiconductor device manufactured thereby.

In addition, the semiconductor device manufactured using the method of forming a photoresist pattern according to the present invention can exhibit improved performance.

### BRIEF DESCRIPTION OF DRAWINGS

The above and other aspects, features, and advantages of the present invention will become apparent from the detailed description of the following embodiments in conjunction with the accompanying drawings:
FIG. 1 is a schematic process diagram illustrating a development step and a cleaning step of a photoresist pattern forming method according to the invention;
FIG. 2 is a schematic diagram of track equipment used in the photoresist pattern forming method according to the invention;
FIG. 3 is a view showing the results of evaluating pattern collapse defects of a photoresist pattern formed according to Example 47; and
FIG. 4 is a view showing the results of evaluating pattern collapse defects of a photoresist pattern formed according to Comparative Example 1.

### DETAILED DESCRIPTION

The present invention relates to a photoresist pattern forming method that can form a pattern with an increased aspect ratio using a typical photoresist, and a semiconductor device manufactured using the same.

Unless otherwise defined herein, all terms including technical or scientific terms used herein have the same meanings as commonly understood by those skilled in the art to which the present invention belongs. It will be further understood that terms, such as those defined in commonly used dictionaries, should be interpreted as having a meaning that is consistent with their meaning in the context of the specification and relevant art and should not be interpreted in an idealized or overly formal sense unless expressly so defined herein.

It will be further understood that the terms "comprises" and/or "comprising," when used in this specification, specify the presence of stated features, steps, operations, elements, and/or components, but do not preclude the presence or addition of one or more other features, steps, operations, elements, components, and/or groups.

As used herein to represent a specific numerical range, the expression "a to b" means "≥ a and ≤ b".

The present invention provides a photoresist pattern forming method including: (a) forming a photoresist film by applying a photoresist composition to a substrate; (b) exposing the formed photoresist film to light; (c) developing the photoresist film exposed to the light using a developer; and (d) cleaning the developed photoresist film, wherein step (d) sequentially includes: cleaning with ultrapure water and cleaning with a rinse solution, and at least one of the ultrapure water or the rinse solution used in step (d) is sprayed at a temperature of 30°C to 90°C.

In addition, the present invention provides a semiconductor device manufactured using the photoresist pattern forming method set forth above.

The photoresist composition used in step (a) includes a positive photoresist composition and a negative photoresist composition. That is, the photoresist composition refers to a resin composition that can form a film having an increased or decreased solubility in an alkaline developer as a result of a chemical reaction induced by exposure to light.

In terms of formation of fine patterns, it is desirable that the photoresist composition be an EUV photoresist composition, which uses EUV as light for exposure.

The substrate used in step (a) may be a glass substrate or a silicon wafer, without being limited thereto.

In step (a), the photoresist composition may be applied to the substrate by any suitable method known in the art, such as spin coating or slit coating.

The light used in step (b) may be one selected from the group consisting of KrF (248 nm), ArF (193 nm), VUV (157 nm), ArFi (38 nm), and EUV (13.5 nm). In terms of formation of fine patterns, it is desirable to use EUV as the light.

The photoresist pattern forming method according to the invention preferably further include: a soft baking step before step (b) and/or a post-exposure baking (PEB) step after step (b).

The soft baking step and the post-exposure baking step may each be independently performed at a temperature of 150°C or less, preferably at a temperature of 110°C or less, more preferably at a temperature of 70°C to 110°C.

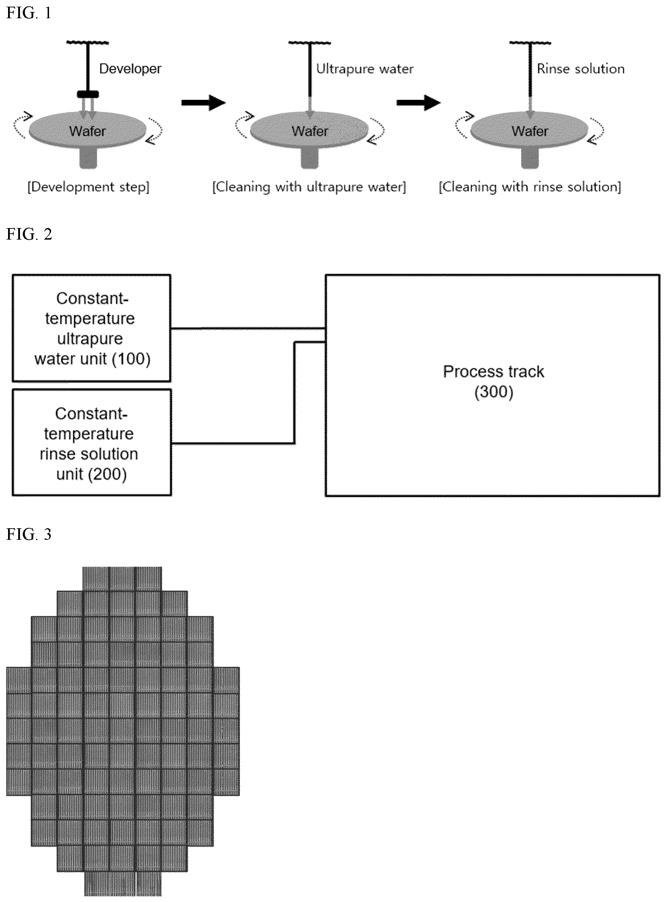

FIG. 1 is a schematic process diagram illustrating a development step (step (c)) and a cleaning step (step (d)) of the photoresist pattern forming method according to the invention. Referring to FIG. 1, the photoresist pattern forming method according to the invention sequentially includes cleaning with ultrapure water and cleaning with a rinse solution, after the development step.

The developer used in step (c) may be an alkaline developer, preferably an aqueous solution containing tetramethylammonium hydroxide (TMAH) at a concentration of 0.01 wt% to 5 wt%.

Development of the photoresist film may be carried out by various methods, such as a method of dipping the substrate in a tank filled with the developer for a certain period of time (dipping method), a method of spraying the developer onto a surface of the substrate, followed by allowing the sprayed developer to stand for a certain period of time while rotating the substrate at a low speed (puddling method), a method of spraying the developer onto the surface of the substrate using a sprayer (spraying method), and the like.

Step (d) is performed to clean the developed photoresist film and sequentially includes cleaning with ultrapure water and cleaning with a rinse solution, after the development step.

The step of cleaning with ultrapure water may include spraying ultrapure water onto the substrate at a flow rate of 1 ml/min to 2,000 ml/min for 1 sec to 300 sec while rotating the substrate at a speed of 1 rpm to 2,000 rpm. Here, the total spraying amount of the ultrapure water may be 100 ml to 5,000 ml.

The step of cleaning with a rinse solution may include spraying a rinse solution onto the substrate at a flow rate of 1 ml/min to 1,000 ml/min for 1 sec to 100 sec while rotating the substrate at a speed of 1 rpm to 1,500 rpm. Here, the total spraying amount of the rinse solution may be 1 ml to 300 ml.

In one embodiment of the invention, at least one of the ultrapure water and the rinse solution used in step (d) may be sprayed at a temperature of 30°C to 90°C, preferably at a temperature of 50°C to 80°C, more preferably at a temperature of 65°C to 75°C.

In another embodiment of the invention, both the ultrapure water and the rinse solution used in step (d) may be sprayed at a temperature of 50°C to 80°C, preferably, at a temperature of 65°C to 75°C.

In a further embodiment of the invention, one of the ultrapure water and the rinse solution used in step (d) may be sprayed at a temperature of 65°C to 75°C, and the other may be sprayed at a temperature of 30°C to 80°C. More preferably, one of the ultrapure water and the rinse solution is sprayed at a temperature of 65°C to 75°C, and the other is sprayed at a temperature of 50°C to 70°C.

In yet another embodiment of the invention, one of the ultrapure water and the rinse solution used in step (d) may be sprayed at a temperature of 50°C to 70°C, and the other may be sprayed at a temperature of 60°C to 80°C.

In formation of a photoresist pattern, aqueous compositions based on ultrapure water are typically used in the post-development cleaning step. However, such an aqueous composition has a relatively high surface tension and forms a high contact angle with a photoresist and thus can cause pattern collapse due to capillary force when used in the cleaning step.

The inventors of the present invention completed the invention by experimentally confirming that pattern collapse during formation of fine patterns can be prevented by use of ultrapure water and an ultrapure water-based rinse solution heated to a temperature (30°C to 90°C) higher than room temperature (20°C to 25°C) in the post-development cleaning step.

As the temperature of the ultrapure water and the rinse solution increases, the kinetic energy of water molecules also increases, weakening hydrogen bonds between the water molecules, which in turn reduces cohesion between the water molecules. As a result, the surface tension, contact angle, and viscosity of the ultrapure water and the rinse solution decrease, causing reduction in capillary force, thereby preventing pattern collapse defects when the ultrapure water and the rinse solution escape from between the fine patterns during a post-cleaning drying process.

In this regard, FIG. 2 is a schematic diagram of track equipment used in the photoresist pattern forming method according to the invention. The track equipment includes: a constant-temperature ultrapure water unit 100 and a constant-temperature rinse solution unit 200 configured to maintain the ultrapure water and the rinse solution used in the cleaning step at constant temperatures, respectively; and a process track 300 configured to perform the cleaning step by spraying the ultrapure water and the rinse solution onto the substrate.

Each of the constant-temperature ultrapure water unit 100 and the constant-temperature rinse solution unit 200 may include a temperature sensor (not shown) configured to detect the temperature of the ultrapure water or the rinse solution stored therein to ensure that the ultrapure water or the rinse solution can maintain a predetermined constant temperature.

The rinse solution used in step (d) may include a surfactant, an additive, water, and, optionally, a solvent.

In one embodiment of the invention, the rinse solution may include a surfactant, an additive, and water.

The surfactant serves to reduce surface tension of the water while increasing interfacial activity, and may include at least one selected from the group consisting of a fluorine surfactant, a hydrocarbon surfactant, a silicone surfactant, an anionic surfactant, and a cationic surfactant.

The fluorine surfactant may include, for example, fluoroacrylic carboxylates, fluoroalkyl ethers, fluoroalkylene ethers, fluoroalkyl sulfates, fluoroalkyl phosphates, fluoroacrylic copolymers, fluorine copolymers, perfluorinated acids, perfluorinated carboxylates, perfluorinated sulfonates, and the like, without being limited thereto.

The hydrocarbon surfactant may include, for example, polyoxyethylene monomethyl ether, polyoxyethylene monoallyl ether, polyoxyethylene-2-ethylhexyl ether, polyoxyethylene decyl ether, polyoxyethylene isotridecyl ether, polyoxyethylene oleyl ether, polyoxyethylene stearyl ether, polyoxyethylene cetyl ether, polyoxyethylene polyoxypropylene tridecyl ether, polyoxyethylene lauryl ether, and the like, without being limited thereto.

The silicone surfactant may include, for example, poly(dimethylsiloxane) ethoxylate, a poly(dimethylsiloxane) ethoxylate/propoxylate copolymer, trimethylsiloxane ethoxylate, a trimethylsiloxane ethoxylate/propoxylate copolymer, and the like, without being limited thereto.

The anionic surfactant may include, for example, disodium laureth sulfosuccinate, disodium lauryl sulfosuccinate, disodium cocoyl glutamate, cocoyl glutamate, disodium hydrogenated tallowyl glutamate, disodium stearoyl glutamate, hydrogenated tallowyl glutamate, lauroyl glutamate, myristoyl glutamate, palmitoyl glutamate, potassium cocoyl glutamate, potassium lauroyl glutamate, potassium myristoyl glutamate, sodium cocoyl glutamate, sodium hydrogenated tallowyl glutamate, sodium lauroyl glutamate, sodium myristoyl glutamate, sodium stearoyl glutamate, stearoyl glutamate, TEA-cocoyl glutamate, TEA-hydrogenated tallowyl glutamate, TEA-lauroyl glutamate, and the like, without being limited thereto.

The cationic surfactant may include, for example, alkyltrimethylammonium chloride, dialkyldimethylammonium chloride, benzalkonium chloride, stearylamine acetate, and the like, without being limited thereto.

The surfactant may be present in an amount of 0.0001 wt% to 1 wt%, preferably 0.001 wt% to 0.5 wt%, based on the total weight of the rinse solution. Within this range, surface tension of the rinse solution can be appropriately reduced without deterioration in cleaning power of the rinse solution.

The additive may include any component within a range that does not significantly impair the desired effects of the present invention. The additive may include, for example, at least one selected from the group consisting of a triol derivative, a tetraol derivative, an antioxidant, an anticorrosive agent, an antifoaming agent, a rust inhibitor, and a preservative, preferably at least one selected from the group consisting of a triol derivative and a tetraol derivative, more preferably a triol derivative. The additive may be present in an amount of 0.0001 wt% to 1 wt%, preferably 0.001 wt% to 0.5 wt%, based on the total weight of the rinse solution.

The triol derivative is a C₃ to C₁₀ compound having three hydroxyl groups (-OH) per molecule, and may be one selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butan-1,1,1-triol, 2-methyl-1,2,3-propanetriol, 5-methylhexan-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydronaphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof.

The tetraol derivative is a C₄ to C₁₄ compound having four hydroxyl groups (-OH) per molecule, and may be selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof.

The solvent may include at least one selected from the group consisting of a hydrocarbon solvent, a ketone solvent, an ester solvent, an alcohol solvent, an amide solvent, and an ether solvent.

The hydrocarbon solvent may include, for example, an aromatic hydrocarbon solvent, such as toluene and xylene, and an aliphatic hydrocarbon solvent, such as pentane, hexane, octane, and decane, without being limited thereto.

The ketone solvent may include, for example, 1-octanone, 2-octanone, 1-nonanone, 2-nonanone, acetone, 4-heptanone, 1-hexanone, 2-hexanone, diisobutyl ketone, cyclohexanone, methylcyclohexanone, phenylacetone, methyl ethyl ketone, methyl isobutyl ketone, acetylacetone, acetonylacetone, ionone, diacetonyl alcohol, acetylcarbinol, acetophenone, methyl naphthyl ketone, isophorone, and propylene carbonate, without being limited thereto.

The ester solvent may include, for example, methyl acetate, butyl acetate, ethyl acetate, isopropyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, methyl formate, ethyl formate, butyl formate, propyl formate, ethyl lactate, butyl lactate, and propyl lactate, without being limited thereto.

The alcohol solvent may include, for example, methyl alcohol, ethyl alcohol, n-propyl alcohol, isopropyl alcohol, n-butyl alcohol, sec-butyl alcohol, tert-butyl alcohol, isobutyl alcohol, n-hexyl alcohol, n-heptyl alcohol, n-octyl alcohol, n-decanol, ethylene glycol, diethylene glycol, and triethylene glycol, without being limited thereto.

The amide solvent may include, for example, N-methyl-2-pyrrolidone, N,N-dimethylacetamide, N,N-dimethylformamide, hexamethylphosphoric triamide, and 1,3-dimethyl-2-imidazolidinone, without being limited thereto.

The ether solvent may include, for example, ethylene glycol monomethyl ether, propylene glycol monomethyl ether, ethylene glycol monoethyl ether, propylene glycol monoethyl ether, diethylene glycol monomethyl ether, triethylene glycol monoethyl ether, methoxymethyl butanol, dioxane, and tetrahydrofuran, without being limited thereto.

When the rinse solution according to the invention includes a solvent, the solvent may be present in an amount of 0.001 wt% to 2 wt%, preferably 0.01 wt% to 1 wt%, based on the total weight of the rinse solution. However, it should be understood that the present invention is not limited thereto and the rinse solution may be free from a solvent.

The water included in the rinse solution may be ultrapure water. In the rinse solution, the water may be present in a balance amount, wherein the balance amount refers to the quantity required to bring the total weight of the rinse solution, including the essential components and other components, to 100 wt%.

Specifically, when the rinse solution is free from a solvent, the water may be present in an amount of 98 wt% to 99.9998 wt%, preferably 99 wt% to 99.998 wt%, based on the total weight of the rinse solution. When the rinse solution includes a solvent, the water may be present in an amount of 96 wt% to 99.9988 wt%, preferably 97 wt% to 99.988 wt%, based on the total weight of the rinse solution.

In one embodiment of the invention, step (d) may further include a drying step. More specifically, step (d) may further include a spin-drying step performed to remove the ultrapure water and the rinse solution remaining on the substrate after the step of cleaning with ultrapure water and the step of cleaning with a rinse solution.

The drying step may include a primary drying step in which the substrate is rotated at a speed of 1 rpm to 300 rpm for 1 sec to 180 sec, and a secondary drying step in which the substrate is rotated at a speed of 10 rpm to 3,000 rpm for 1 sec to 120 sec.

In one embodiment of the invention, step (d) may be performed without using isopropyl alcohol.

A photoresist pattern formed by the photoresist pattern forming method according to the invention may have a critical dimension (CD) of 25 nm or less, preferably 20 nm or less, more preferably 18 nm or less.

In addition, the photoresist pattern formed by the photoresist pattern forming method according to the invention may have an aspect ratio (height/critical dimension) of 1.5 or more, preferably 2.0 or more, more preferably 2.2 or more.

Next, the present invention will be described in more detail with reference to the following Examples. However, it should be noted that these examples are provided for illustration only and are not to be construed in any way as limiting the present invention.

### <EXAMPLE>

### Examples 1 to 63 and Comparative Examples 1 to 9: Formation of photoresist pattern

A chemically amplified PHS acrylate-hydrate hybrid EUV resist was applied to a 12-inch silicon wafer (SK Siltron Co., Ltd.) using a spin coater, followed by soft baking at 110°C for 60 sec, thereby forming a photoresist film having a thickness of 400 Å. The photoresist film formed on the wafer was subjected to exposure in an EUV exposure apparatus through a mask to form an 18 nm line-and-space pattern (line:space = 1:1) on the photoresist film, followed by post-exposure baking (PEB) at 110°C for 60 sec. The photoresist film subjected to exposure was puddle-developed for 32 sec using an aqueous solution containing 2.38 wt% of tetramethylammonium hydroxide (TMAH).

Ultrapure water was poured onto the puddle of developer on the developed photoresist film and the wafer, followed by spraying ultrapure water at a flow rate of 1,500 ml/min for 60 sec while rotating the wafer at a speed of 1,000 rpm to replace the developer with the ultrapure water, and then a rinse solution (0.001 wt% of fluoroacryl carboxylate, 0.001 wt% of 1,2,3-propanetriol, and 99.998 wt% of ultrapure water) was sprayed at a flow rate of 500 ml/min for 10 sec while rotating the wafer at a speed of 500 rpm to replace the ultrapure water with the rinse solution. Thereafter, the wafer was dried by rotating the wafer at a speed of 2,000 rpm for 60 sec.

The temperatures of the ultrapure water and the rinse solution used in the above process were as shown in Tables 1 and 2. In Comparative Examples 1 to 8, the drying step was performed immediately after the step of cleaning with ultrapure water without performing the step of cleaning with a rinse solution.

In addition, in the step of cleaning with ultrapure water and the step of cleaning with a rinse solution according to Examples 1 to 63, the ultrapure water and the rinse solution were maintained at a predetermined constant temperature using the constant-temperature ultrapure water unit 100 and the constant-temperature rinse solution unit 200 shown in FIG. 2.

Conversely, in the step of cleaning with ultrapure water and/or the step of cleaning with a rinse solution according to Comparative Examples 1 and 9, ultrapure water and/or a rinse solution at room temperature (23°C) were used without using a separate constant-temperature unit.

**Table 1**

| | Temperature of ultrapure water (°C) | Temperature of rinse solution (°C) | | Temperature of ultrapure water (°C) | Temperature of rinse solution (°C) |
|---|---|---|---|---|---|
| Example 1 | 30 | 23 | Example 21 | 30 | 90 |
| Example 2 | 40 | 23 | Example 22 | 40 | 30 |
| Example 3 | 50 | 23 | Example 23 | 40 | 40 |
| Example 4 | 60 | 23 | Example 24 | 40 | 50 |
| Example 5 | 70 | 23 | Example 25 | 40 | 60 |
| Example 6 | 80 | 23 | Example 26 | 40 | 70 |
| Example 7 | 90 | 23 | Example 27 | 40 | 80 |
| Example 8 | 23 | 30 | Example 28 | 40 | 90 |
| Example 9 | 23 | 40 | Example 29 | 50 | 30 |
| Example 10 | 23 | 50 | Example 30 | 50 | 40 |
| Example 11 | 23 | 60 | Example 31 | 50 | 50 |
| Example 12 | 23 | 70 | Example 32 | 50 | 60 |
| Example 13 | 23 | 80 | Example 33 | 50 | 70 |
| Example 14 | 23 | 90 | Example 34 | 50 | 80 |
| Example 15 | 30 | 30 | Example 35 | 50 | 90 |
| Example 16 | 30 | 40 | Example 36 | 60 | 30 |
| Example 17 | 30 | 50 | Example 37 | 60 | 40 |
| Example 18 | 30 | 60 | Example 38 | 60 | 50 |
| Example 19 | 30 | 70 | Example 39 | 60 | 60 |
| Example 20 | 30 | 80 | Example 40 | 60 | 70 |

**Table 2**

| | Temperature of ultrapure water (°C) | Temperature of rinse solution (°C) | | Temperature of ultrapure water (°C) | Temperature of rinse solution (°C) |
|---|---|---|---|---|---|
| Example 41 | 60 | 80 | Example 57 | 90 | 30 |
| Example 42 | 60 | 90 | Example 58 | 90 | 40 |
| Example 43 | 70 | 30 | Example 59 | 90 | 50 |
| Example 44 | 70 | 40 | Example 60 | 90 | 60 |
| Example 45 | 70 | 50 | Example 61 | 90 | 70 |
| Example 46 | 70 | 60 | Example 62 | 90 | 80 |
| Example 47 | 70 | 70 | Example 63 | 90 | 90 |
| Example 48 | 70 | 80 | Comparative Example 1 | 23 | Not used |
| Example 49 | 70 | 90 | Comparative Example 2 | 30 | Not used |
| Example 50 | 80 | 30 | Comparative Example 3 | 40 | Not used |
| Example 51 | 80 | 40 | Comparative Example 4 | 50 | Not used |
| Example 52 | 80 | 50 | Comparative Example 5 | 60 | Not used |
| Example 53 | 80 | 60 | Comparative Example 6 | 70 | Not used |
| Example 54 | 80 | 70 | Comparative Example 7 | 80 | Not used |
| Example 55 | 80 | 80 | Comparative Example 8 | 90 | Not used |
| Example 56 | 80 | 90 | Comparative Example 9 | 23 | 23 |

### <Experimental Example>

### Evaluation of Pattern Collapse Defect

The patterns formed according to Examples and Comparative Examples were evaluated as to pattern collapse defects using a critical dimension-scanning electron microscope (CD-SEM, Hitachi, Ltd.). The number of collapse-free blocks out of a total of 89 blocks on the wafer was ascertained. Results are shown in Tables 3 and 4.

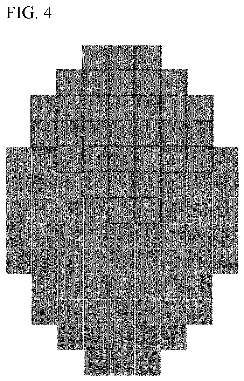

In this regard, FIG. 3 is a view showing the results of evaluating pattern collapse defects of the photoresist pattern formed according to Example 47, and FIG. 4 is a view showing the results of evaluating pattern collapse defects of the photoresist pattern formed according to Comparative Example 1. In FIG. 3 and FIG. 4, collapse-free blocks are indicated in red.

**Table 3**

| | Number of collapse-free blocks | | Number of collapse-free blocks |
|---|---|---|---|
| Example 1 | 70 | Example 21 | 72 |
| Example 2 | 71 | Example 22 | 72 |
| Example 3 | 74 | Example 23 | 74 |
| Example 4 | 77 | Example 24 | 77 |
| Example 5 | 80 | Example 25 | 80 |
| Example 6 | 76 | Example 26 | 83 |
| Example 7 | 69 | Example 27 | 79 |
| Example 8 | 70 | Example 28 | 71 |
| Example 9 | 72 | Example 29 | 75 |
| Example 10 | 75 | Example 30 | 76 |
| Example 11 | 78 | Example 31 | 78 |
| Example 12 | 82 | Example 32 | 81 |
| Example 13 | 79 | Example 33 | 84 |
| Example 14 | 71 | Example 34 | 81 |
| Example 15 | 71 | Example 35 | 72 |
| Example 16 | 73 | Example 36 | 78 |
| Example 17 | 76 | Example 37 | 79 |
| Example 18 | 78 | Example 38 | 81 |
| Example 19 | 82 | Example 39 | 83 |
| Example 20 | 79 | Example 40 | 85 |

**Table 4**

| | Number of collapse-free blocks | | Number of collapse-free blocks |
|---|---|---|---|
| Example 41 | 81 | Example 57 | 76 |
| Example 42 | 70 | Example 58 | 74 |
| Example 43 | 81 | Example 59 | 74 |
| Example 44 | 82 | Example 60 | 75 |
| Example 45 | 83 | Example 61 | 76 |
| Example 46 | 84 | Example 62 | 71 |
| Example 47 | 86 | Example 63 | 65 |
| Example 48 | 81 | Comparative Example 1 | 33 |
| Example 49 | 70 | Comparative Example 2 | 40 |
| Example 50 | 77 | Comparative Example 3 | 41 |
| Example 51 | 78 | Comparative Example 4 | 42 |
| Example 52 | 79 | Comparative Example 5 | 44 |
| Example 53 | 79 | Comparative Example 6 | 48 |
| Example 54 | 81 | Comparative Example 7 | 46 |
| Example 55 | 76 | Comparative Example 8 | 42 |
| Example 56 | 69 | Comparative Example 9 | 61 |

Referring to Tables 3 and 4, it can be seen that the photoresist patterns according to Examples 1 to 63, formed using ultrapure water and/or a rinse solution heated to a temperature of 30°C to 90°C in the post-development cleaning step, showed good results, with 65 or more collapse-free blocks, compared to the photoresist pattern according to Comparative Example 9, formed using ultrapure water and a rinse solution at room temperature in the post-development cleaning step. In particular, it can be seen that the photoresist patterns according to Examples, in which both the ultrapure water and the rinse solution were sprayed at a temperature of 50°C to 80°C in the post-development cleaning step, showed even better results, with 76 or more collapse-free blocks.

Conversely, the photoresist pattern according to Comparative Example 1, formed using only ultrapure water at room temperature in the post-development cleaning step, showed the worst results, with only 33 collapse-free blocks, and the photoresist patterns according to Comparative Examples 2 to 8, formed using only ultrapure water at 30°C to 90°C in the post-development cleaning step, had 48 or fewer collapse-free blocks, indicating that, even when high-temperature ultrapure water is used, pattern collapse defects cannot be prevented without the step of cleaning with a rinse solution.

## Claims

1. A method of forming a photoresist pattern, comprising:
(a) forming a photoresist film by applying a photoresist composition to a substrate;
(b) exposing the formed photoresist film to light;
(c) developing the photoresist film exposed to the light using a developer; and
(d) cleaning the developed photoresist film,
wherein step (d) sequentially comprises cleaning with ultrapure water and cleaning with a rinse solution, and
at least one of the ultrapure water or the rinse solution used in step (d) is sprayed at a temperature of 30°C to 90°C.

2. The method according to claim 1, wherein at least one of the ultrapure water or the rinse solution used in step (d) is sprayed at a temperature of 50°C to 80°C.

3. The method according to claim 1, wherein at least one of the ultrapure water or the rinse solution used in step (d) is sprayed at a temperature of 65°C to 75°C.

4. The method according to claim 1, wherein the step of cleaning with ultrapure water comprises spraying the ultrapure water onto the substrate at a flow rate of 1 ml/min to 2,000 ml/min for 1 sec to 300 sec while rotating the substrate at a speed of 1 rpm to 2,000 rpm.

5. The method according to claim 1, wherein the step of cleaning with a rinse solution comprises spraying the rinse solution onto the substrate at a flow rate of 1 ml/min to 1,000 ml/min for 1 sec to 100 sec while rotating the substrate at a speed of 1 rpm to 1,500 rpm.

6. The method according to claim 1, wherein the rinse solution comprises a surfactant, an additive, and water.

7. The method according to claim 6, wherein the rinse solution comprises:
0.0001 wt% to 1 wt% of the surfactant;
0.0001 wt% to 1 wt% of the additive; and
the balance of water, based on the total weight of the rinse solution.

8. The method according to claim 1, wherein the photoresist pattern has a critical dimension of 25 nm or less.

9. The method according to claim 1, wherein the photoresist pattern has an aspect ratio (height/critical dimension) of 1.5 or more.

10. The method according to claim 1, wherein the light used in step (b) is one selected from the group consisting of KrF, ArF, VUV, ArFi, and EUV.

11. A semiconductor device manufactured using the method of forming a photoresist pattern according to any one of claims 1 to 10.
